# EUROPÄISCHE PATENTSCHRIFT

(11) **EP 0 259 723 B1**
(45) Veröffentlichungstag und Bekanntmachung des Hinweises auf die Patenterteilung: **07.04.1993**
(21) Anmeldenummer: 87112551.4
(22) Anmeldetag: 28.08.1987
(51) Int. Cl.: G03F 7/038

(54) **Verfahren zur Herstellung wärmebeständiger strukturierter Schichten**
Process for obtaining heat-resistant structural layers
Procédé de fabrication de couches structurées résistantes à la chaleur

(30) Priorität: 11.09.1986 DE 3630997
(43) Veröffentlichungstag der Anmeldung: 16.03.1988
(73) Patentinhaber: SIEMENS AKTIENGESELLSCHAFT, 80333 München (DE)
(72) Erfinder: Ahne, Hellmut, Dr., D-8551 Röttenbach (DE); Plundrich, Winfried, D-8500 Nürnberg (DE)

(56) Entgegenhaltungen:
- US-A- 3 644 289
- US-A- 3 694 415

## Beschreibung

Die Erfindung betrifft ein Verfahren zur Herstellung wärmebeständiger strukturierter Schichten durch Auftragen strahlungsempfindlicher löslicher Polymerer in Form einer Schicht oder Folie auf ein Substrat, Bestrahlen der Schicht bzw. Folie durch Negativvorlagen mit aktinischem Licht oder durch Führen eines Licht-, Elektronen-, Laser- oder Ionenstrahls, Entfernen der nicht-bestrahlten Schicht- bzw. Folienteile und gegebenenfalls durch nachfolgendes Tempern, sowie die Verwendung dieser strukturierten Schichten.

Verfahren zur Herstellung strukturierter Schichten auf der Basis wärmebeständiger Polymerer sind beispielsweise aus der deutschen Patentschrift 2 308 830 sowie aus den europäischen Patentschriften 0 019 123 und 0 026 820 bekannt. Bei diesen Verfahren werden lösliche photoreaktive Vorstufen hochwärmebeständiger Polymerer zur photolithographischen Strukturierung eingesetzt und die daraus hergestellten Strukturen in einem anschließenden Temperschritt zu hochwärmebeständigen Strukturen cyclisiert. Für die vollständige Cyclisierung und die Entfernung der Spaltprodukte werden Temperaturen bis zu 400°C benötigt. Dies erfordert thermisch hochbelastbare Substrate.

Auf dem Schaltungs- und Leitungssektor, beispielsweise in der Leiterplattentechnik, werden unter anderem Substrate auf Epoxidbasis verwendet, die thermisch maximal bis zu ca. 150°C/1 h belastet werden können und die nur im Sekundenbereich Temperaturen von ca. 280°C standhalten müssen, beispielsweise bei Lötprozessen. Die hier zur partiellen Leiterbahnabdeckung eingesetzten sogenannten Lötstopplacke müssen ähnlichen thermischen Anforderungen entsprechen, d.h. hierbei werden zur Abdeckung der Stellen der Schaltungsoberfläche, die nicht mit dem Lotmetall in Kontakt treten sollen, Polymere mit einer mittleren thermischen Beständigkeit benötigt. Die bisher zu diesem Zweck (noch) eingesetzten Trockenresists bzw. Siebdrucklacke auf Epoxid- und Acrylatbasis entsprechen zwar den Anforderungen einer Lötstoppmaske, erfüllen jedoch nur zum Teil die gestiegenen Anforderungen an die Maßgenauigkeit in der Feinstleitertechnik mit Strukturen <100 µm, sowie die geforderte Cycelfestigkeit. Hierfür werden photolithographische Lacksysteme benötigt.

Es ist zwar bereits ein photostrukturierbares Lacksystem auf Epoxidbasis mit in die Polymerkette eingebauten Chalkongruppen, d.h. Gruppen der Struktur -C₆H₄-CH=CH-CO-C₆H₄-, verfügbar, das eine ausreichende Maßgenauigkeit gewährleistet (siehe: "Chimia", Bd. 38 (1984), Seiten 13 bis 20). Was die Photostrukturierbarkeit anbetrifft, sind hierbei jedoch relativ lange Belichtungszeiten und insbesondere lange Entwicklungszeiten erforderlich. Darüber hinaus kann mit dem bekannten Lacksystem ein zusätzlicher dauerhafter Schutz der gegen Schadgas empfindlichen Schaltungsoberfläche, wie er oft gefordert wird, nur durch eine aufwendige Mehrfachbeschichtung erreicht werden. Ferner ist der Prozeßablauf, bedingt durch mehrstündige Nachhärtungszeiten, lang und kostenintensiv.

Aufgabe der Erfindung ist es, ein Verfahren der eingangs genannten Art in der Weise auszugestalten, daß es möglich ist, dimensionsgenaue, qualitativ hochwertige strukturierte Schichten, insbesondere auf Schaltungsoberflächen, in einem einzigen Beschichtungsvorgang herzustellen, die auch den umfangreichen thermischen und mechanischen Beanspruchungen, beispielsweise bei Tauchlötprozessen, standhalten und darüber hinaus die Schaltungsoberfläche wirksam und dauerhaft gegen Feuchte und Korrosion schützen. Insbesondere soll der Prozeßdurchlauf durch kurze Belichtungs-, Entwicklungs- und Temperzeiten verkürzt und dadurch kostengünstig gestaltet werden. Daneben soll der Entwicklungsprozeß zu hochaufgelösten Strukturen führen, wobei insbesondere auch die Möglichkeit gegeben sein soll, im wäßrig-alkalischen Medium zu arbeiten.

Dies wird erfindungsgemäß dadurch erreicht, daß Photopolymere in Form von Additionsprodukten von olefinisch ungesättigten Monoisocyanaten mit Phenol-Formaldehyd-Harzen verwendet werden, wobei als olefinisch vugesättigtes Monoisocyanat ein methacrylatgruppenhaltiges Isocyanat oder ein Additionsprodukt von Hydroxyethyl(meth)acrylat an 2,4-Diisocyanatotoluol eingesetzt wird.

Das erfindungsgemäße Verfahren erlaubt - im Rahmen eines kostengünstigen Prozeßablaufes - die Herstellung feinstrukturierter Schutz- und Isolierschichten für den Halbleiter- und Schaltungssektor, die die gegen Korrosion empfindlichen Bauteile und Schaltungen dauerhaft wirksam schützen. Besonders vorteilhaft ist dabei, daß der Entwicklungsprozeß nicht zum Unterlösen führt und somit bei Lötprozessen keine Lotbrücken auftreten. Das erfindungsgemäße Verfahren erfüllt ferner nicht nur die hinsichtlich der Maßgenauigkeit der erzeugten Strukturen gestellten Anforderungen, sondern es ermöglicht darüber hinaus eine sehr hohe Auflösung in einem breiten Schichtdickenbereich mit kurzen Entwicklungszeiten. Dieses Verfahren ist ferner kostengünstig, insbesondere auch deshalb, weil es bei einmaligem Auftrag (mit konventionellem Equipment) - gegebenenfalls nach kurzzeitiger Temperung - photostrukturierte Schichten mit ausreichend hoher Wärmebeständigkeit ergibt, die - auch unter Lötbadbedingungen - formstabil und rißfrei bleiben und als dauerhafter Schutz gegen Feuchte und Korrosion wirksam sind. Die guten elektrischen Kennwerte werden dabei auch im Feuchteklima nicht beeinträchtigt.

Beim erfindungsgemäßen Verfahren werden aus den photoreaktiven Phenol-Formaldehyd-Harzen bei Einwirkung von aktinischem Licht, wie UV-Licht, photovernetzte Strukturen erhalten, die auch wäßrig-alkalisch entwickelt werden können und dabei hochaufgelöste Reliefstrukturen ergeben. Dies ist deshalb von Bedeutung, weil dann keine Sicherheitsmaßnahmen wie Brand- und Exschutz erforderlich sind, wie dies beim Einsatz organischer Entwickler der Fall ist.

Die nach dem erfindungsgemäßen Verfahren hergestellten photovernetzten Schichten auf der Basis von Phenol-Formaldehyd-Harzen eignen sich als Isolierschicht auf Kupfersubstraten sowie als flexible Schutz- und Isolierschicht auf Polyimidfolien und Leiterplatten mit Leiterbahnen aus Kupfer bzw. mit Kupferoxidoberflächen. Die Haftung auf Kupfer-, Polyimid- und Leiterplattensubstraten ist sehr gut und erfüllt die gestellten Anforderungen. Im Gegensatz dazu sind die aus bekannten Photolacken auf Phenol-Formaldehyd-Basis hergestellten Strukturen nicht als dauerhafte Schutz- und Isolierschicht geeignet. Diese Photolacke, die positiv arbeitende Resists darstellen, enthalten nämlich - neben nicht-strahlungsreaktiven Phenol-Formaldehyd-Harzen - bis zu 30 % an thermisch labilen Diazochinonen, welche die Isolierstoffeigenschaften beeinträchtigen.

Beim erfindungsgemäßen Verfahren können die Photopolymeren vorteilhaft zusammen mit licht- oder strahlungsempfindlichen copolymerisationsfähigen Verbindungen eingesetzt werden. Dazu werden vorzugsweise acrylat- und methacrylatgruppenhaltige Verbindungen verwendet, insbesondere Trimethylolpropantriacrylat und -methacrylat und/oder 1.4-Butandioldimethacrylat. Es können aber auch allylgruppenhaltige Verbindungen, beispielsweise Diallyl- und Triallylcyanurate, sowie N-substituierte Maleinimide eingesetzt werden. Weiter können auch Photoinitiatoren und/oder -sensibilisatoren verwendet werden (vgl.: "Industrie Chimique Belge", Vol. 24, 1959, Seiten 739 bis 764, sowie J.Kosar, "Light-Sensitive Systems", John Wiley & Sons Inc., New York 1965, Seiten 143 bis 146 und 160 bis 188). Besonders geeignet sind α-Halogenacetophenone, Dialkoxyacetophenone, wie Dimethoxy- und Diethoxyacetophenon, Benzoylphosphinoxide, die gegebenenfalls substituiert sein können, und Michler's Keton. Als Photoinitiatoren bzw. -sensibilisatoren eignen sich beispielsweise aber auch Benzoinether, 4.4ʹ-Bis(diethylamino)-benzophenon, 2.6-Bis(p-azidobenzyliden)-4-methylcyclohexanon, Thioxanthone, wie Isopropylthioxanthon, und Acetophenon. Ferner können beim erfindungsgemäßen Verfahren vorteilhaft Haftvermittler verwendet werden. Dazu dienen insbesondere Silane, wie Vinyltriethoxysilan, Vinyl-tris(β-methoxyethoxy)-silan, γ-Methacryloxypropyl-trimethoxysilan, γ-Glycidoxypropyl-trimethoxysilan und γ-Aminopropyl-triethoxysilan. Den Lösungen der Photopolymeren können ferner vorteilhaft mineralische Füllstoffe, insbesondere auf Siliciumdioxid- und Aluminiumoxidbasis, sowie weitere, üblicherweise eingesetzte Füllstoffe zugegeben werden.

Die beim erfindungsgemäßen Verfahren eingesetzten Photopolymeren weisen im allgemeinen folgende Struktur auf: 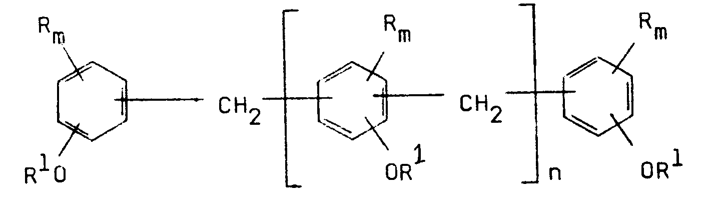
Dabei ist n = R¹ bis 10 und m = 1 bis 3.

Für R und R¹ gilt folgendes:
- R: ist Wasserstoff, Halogen oder eine Alkylgruppe;
- R¹: ist Wasserstoff oder 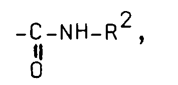 wobei aber nicht alle Reste R¹ gleichzeitig Wasserstoff sein können;
R² ist dabei eine gegebenenfalls substituierte (meth)acrylesterhaltige Gruppe.

Den Photopolymeren können Phenolharze, Alkylphenolharze, Kresolharze und ähnliche Harzsysteme zugrundeliegen; diese Harze können darüber hinaus halogeniert sein. Bevorzugt werden als Phenol-Formaldehyd-Harze Novolake eingesetzt. Novolake bzw. Phenol-Formaldehyd-Harze allgemein weisen im übrigen phenolische Hydroxylgruppen auf, an die - bei der Herstellung der Photopolymeren - die olefinisch ungesättigten Monoisocyanate angelagert werden.

Die Photopolymere sind Additionsprodukte von Isocyanatoethylmethacrylat und Novolaken oder Additionsprodukte von Novolaken mit olefinisch ungesättigten Monoisocyanaten in Form von Additionsprodukten aus 2.4-Diisocyanatotoluol und Hydroxyethylacrylat oder -methacrylat.

Die Herstellung der erfindungsgemäßen strukturierten Schichten erfolgt, wie bereits ausgeführt, in der Weise, daß das Photopolymere in Form einer Schicht oder Folie auf ein Substrat aufgebracht und mit aktinischem Licht durch eine Maske belichtet oder durch Führen eines Licht-, Elektronen-, Laser- oder Ionenstrahls bestrahlt wird. Anschließend werden die nicht-belichteten bzw. nicht-bestrahlten Schicht- oder Folienteile herausgelöst oder abgezogen und die dabei erhaltenen strukturierten Schichten bzw. Reliefstrukturen gegebenenfalls getempert. Das Photopolymere wird dabei vorteilhaft in einem organischen Lösungsmittel gelöst auf das Substrat aufgebracht. Die Konzentration des Photopolymeren in gängigen Lösungsmitteln, wie Cyclohexanon, γ-Butyrolacton, N-Methylpyrrolidon und Gemischen davon, kann so eingestellt werden, daß mit bekannten Beschichtungsverfahren, wie Schleudern, Tauchen, Sprühen, Gießen, Rakeln, Bürsten oder Rollen, Schichtstärken von 0,01 bis ca. 500 µm erzeugt werden können. Zur Erzielung einer gleichmäßigen und guten Oberflächenqualität auf Substraten mit glatter Oberfläche haben sich das Gießverfahren (ein derartiges Verfahren ist beispielsweise aus der europäischen Patentschrift 0 002 040 bekannt), das Rakeln und insbesondere die elektrostatische Sprühbeschichtung und das Schleuderbeschichten bei 300 bis 10000 Umdrehungen/Minute als vorteilhaft erwiesen. Bei unebenen Oberflächen, wie Leiterplatten mit Kupfer-Leiterbahnen auf der Oberfläche, sind Schleuderdrehzahlen von 300 bis 1500 vorteilhaft. Der Viskositätsbereich der für das Rakeln, das Sprühen und das Gießverfahren eingesetzten Lacklösungen liegt vorteilhaft zwischen 200 und 1500 mPa.s bei 23°C.

Die auf das Substrat, das vorzugsweise aus Leiterplattenmaterial, Glas, Metall, Kunststoff oder Halbleitern besteht, aufgebrachte Photolackschicht kann bei Raumtemperatur, vorzugsweise bei Temperaturen von 50 bis 80°C, in einem Stickstoff- oder Luftstrom vom Lösungsmittel befreit werden; dabei kann auch im Vakuum gearbeitet oder mit Infrarotstrahlern bzw. auf einer beheizten Platte getrocknet werden.

Zur Erzielung eines ausreichenden Löslichkeitsunterschiedes zwischen den bestrahlten und den nicht-bestrahlten Schicht-bzw. Folienteilen genügen beim erfindungsgemäßen Verfahren, bei Verwendung einer 350 W-Quecksilberhöchstdrucklampe, in Abhängigkeit von der Zusammensetzung und der Schichtstärke Belichtungszeiten zwischen 5 und 400 s. Nach dem Belichten werden, gegebenenfalls nach einem Nachtrocknungsprozeß, die nicht-belichteten Teile mit organischen Lösungsmitteln, vorzugsweise jedoch wäßrig-alkalisch, herausgelöst.

Die nach dem erfindungsgemäßen Verfahren hergestellten strukturierten Schichten bzw. Reliefstrukturen zeichnen sich durch Kantenschärfe, hohe Auflösung, eine rißfreie homogene Oberfläche und eine Wärmeformbeständigkeit aus, die auch den thermischen und mechanischen Beanspruchungen eines Tauchlötprozesses standhält. Die Haftung zum Lot ist sehr gering, so daß, wie erwünscht, keine Lotperlen an der Polymerschicht hängenbleiben. Die erfindungsgemäß hergestellten strukturierten Schichten sind elastisch genug, um Cyceltests zwischen -65 und +125°C ohne Rißbildung zu bestehen. Mit den strukturierten Schichten abgedeckte Schaltungsoberflächen zeigen in Klimatests bei 40°C und 92 % Luftfeuchte unter Spannung (100 V) keine Leiterbahnkorrosion. Derartige Schichten eignen sich also - neben der Anwendung als Lötstoppmasken - auch als wirksame und dauerhafte Schutzschichten gegen Feuchte- und Schadgaseinwirkung.

Die erfindungsgemäßen strukturierten Schichten eignen sich, wegen der - herstellungsbedingt - hohen Reinheit, auch zur Herstellung von Passivierungsschichten auf Halbleiterbauelementen, von Dünn- und Dickfilmschaltungen, von Lötschutzschichten auf Mehrlagenverschaltungen, von Isolierschichten als Bestandteil von Schichtschaltungen und von miniaturisierten Schutz- und Isolierschichten auf elektrisch leitenden und/oder halbleitenden und/oder isolierenden Basismaterialien, und allgemein zur Feinstrukturierung von Substraten und für Strukturübertragungsprozesse, wie Naß- und Trockenätzprozesse, stromlose oder galvanische Metallabscheidung und Aufdampfverfahren, sowie als Masken für die Ionenimplantation. Darüber hinaus eignen sich diese Schichten als Isolier-und Schutzschichten in der Elektrotechnik und in der Mikroelektronik, sowie als Dämpfungsmassen für Oberflächenwellenfilter, insbesondere Fernsehzwischenfrequenzfilter, ferner als Orientierungsschichten in Flüssigkristalldisplays sowie als Dielektrikum bei der Mehrlagenverschaltung.

Anhand von Ausführungsbeispielen soll die Erfindung noch näher erläutert werden.

### Beispiel 1

Zu einer Lösung von 51,6 Masseteilen des Novolakharzes Bakelite LG 724 (Bakelite^{R} ist ein Warenzeichen der Fa. Bakelite GmbH) in 80 Masseteilen Cyclohexanon werden 41,4 Masseteile reines Isocyanatoethylmethacrylat und 0,1 Masseteile Dibutylzinndilaurat gegeben, dann wird das Gemisch bei Raumtemperatur 48 Stunden gerührt. Danach werden 100 Masseteilen der Harzlösung 0,5 Masseteile Dichloracetophenon, 1,5 Masseteile Diethoxyacetophenon, 0,5 Masseteile Michler's Keton und 0,5 Masseteile Vinyl-tris(β-methoxyethoxy)-silan zugesetzt. Nachfolgend wird die Lösung durch ein 5 µm-Filter druckfiltriert.

Die filtrierte Lösung des photoreaktiven Phenol-Formaldehyd-Harzes wird bei 400 Umdrehungen/Minute auf eine Leiterplatten-Testplatte mit Kupfer-Leiterbahnen auf der Oberfläche geschleudert und danach 1/2 Stunde bei 70°C im Umluftofen getrocknet. Die Dicke der Lackschicht beträgt dann 40 µm. Nach Belichten mit einer 350 W-Quecksilberhöchstdrucklampe durch eine Maske für 10 s und nach 2minütigem Nachtrocknen bei 90°C im Umluftofen werden mit wäßrig-alkalischen Entwicklern, wie AZ 303 (Fa. Shipley), wobei Wasser als Stopper verwendet wird, nach 25 s kantenscharfe strukturierte Schichten erhalten, die in ihrer Oberflächenqualität auch durch hundertmaliges Cyceln zwischen -65 und +125°C nicht beeinträchtigt werden. Diese Schichten widerstehen ebenso unbeschadet Schwall- und Tauchlötprozessen bei 260°C; das Lot perlt von der Oberfläche ab. Feuchtetests bei 40°C und 92 % Luftfeuchte und unter einer Spannung von 100 V zeigen keine Korrosion in den mit Lack abgedeckten Leiterbahnbereichen.

### Beispiel 2

Zu einer Lösung von 66,8 Masseteilen reinem 2.4-Diisocyanatotoluol in 115 Masseteilen Dichlormethan wird bei Raumtemperatur unter Rühren und Feuchteausschluß ein Gemisch von 23,6 Masseteilen reinem 2-Hydroxyethylacrylat und 24,8 Masseteilen reinem 2-Hydroxyethylmethacrylat langsam zugetropft. Nach 30stündiger Reaktion bei Raumtemperatur wird durch Titration ein Isocyanatumsatz von 98 % ermittelt.

Die erhaltene Lösung des photoreaktiven Monoisocyanats wird mit einer Lösung von 75 Masseteilen des Novolakharzes Bakelite LG 724 in 60 Masseteilen γ-Butyrolacton und mit 0,1 Masseteilen Dibutylzinndilaurat vereinigt. Nach 24stündiger Reaktion bei Raumtemperatur werden zur Reaktionslösung 15 Masseteile Ethanol gegeben. Nach weiteren 24 Stunden ist die Lösung für Beschichtungen gebrauchsfertig.

Zu 100 Masseteilen der in der geschilderten Weise hergestellten Lösung des Photopolymeren werden 1,2 Masseteile 2.4.6-Trimethyl-benzoylphosphinoxid, 0,3 Masseteile Michler's Keton, 0,3 Masseteile Vinyltriethoxysilan und 30 Masseteile Talkum (als Füllstoff) gegeben. Im Gießverfahren werden dann auf Kupfersubstraten 30 µm dicke Lackschichten hergestellt und mit einer 350 W-Quecksilberhöchstdrucklampe 30 s durch eine Maske bestrahlt. Nach dem Entwickeln mit Cyclohexanon und Wasser als Stopper (Dauer: 30 s) werden Strukturen mit glatter rißfreier Oberfläche erhalten, die unter Lötbadbedingungen auch bei 260°C stabil sind; das Lot haftet nicht an der Lackoberfläche, sondern perlt ab.

### Beispiel 3

103,2 Masseteile des Novolakharzes Bakelite 6564 LB werden unter Erwärmen auf ca. 100°C mit 60 Masseteilen getrocknetem Cyclohexanon gelöst, dann mit 0,2 Masseteilen Dibutylzinndilaurat und mit 123,8 Masseteilen reinem Isocyanatoethylmethacrylat versetzt und bei Raumtemperatur ca. 24 Stunden zur Reaktion gebracht. Danach werden zur Reaktionslösung 12 Masseteile Ethanol gegeben, um restliche Isocyanatgruppen umzusetzen. Die Lösung wird dann 24 Stunden bei Raumtemperatur stehen gelassen.

Zu 100 Masseteilen des in der vorstehend beschriebenen Weise - als 55 %ige Harzlösung - hergestellten photoreaktiven Phenol-Formaldehyd-Harzes werden 2,2 Masseteile Benzoinisopropylether, 0,5 Masseteile Michler's Keton, 2,7 Masseteile Trimethylolpropantriacrylat und 0,5 Masseteile Vinyl-tris(β-methoxyethoxy)-silan gegeben. Die Lösung wird dann durch ein 15 µm-Filter druckfiltriert. Die Viskosität der dabei erhaltenen Lösung ist größer als 1000 mPa.s bei 23°C.

Durch Aufschleudern der Lösung bei 1500 Umdrehungen/Minute auf eine mit einem Haftvermittler beschichtete Siliciumscheibe werden nach 30minütigem Trocknen bei 70°C in einem Umluftofen 25 µm dicke homogene Schichten erhalten, die nach einer Belichtung von 40 s mit einer 350 W-Quecksilberhöchstdrucklampe durch eine Maske mit γ-Butyrolacton/Xylol (Volumenverhältnis 1:2) und Nachspülen mit Xylol im Sprühverfahren zu konturenscharfen strukturierten Schichten entwickelt werden. Die Kantenausbildung und die Oberflächenqualität dieser Schichten werden durch einstündiges Tempern bei 150°C nicht beeinträchtigt. Die aufgelösten Strukturen liegen bei ≦25 µm.

Eine mit bekannten käuflichen Flußmitteln behandelte photostrukturierte Schicht zeigt nach dem Lötbadtest bei 260°C und 20 s Tauchzeit eine homogene rißfreie Oberfläche. Das Lot perlt von der Lackoberfläche gut ab.

## Patentansprüche

1. Verfahren zur Herstellung wärmebeständiger strukturierter Schichten durch Auftragen strahlungsempfindlicher löslicher Polymere in Form einer Schicht oder Folie auf ein Substrat, Bestrahlen der Schicht bzw. Folie durch Negativvorlagen mit aktinischem Licht oder durch Führen eines Licht-, Elektronen-, Laser- oder Ionenstrahls, Entfernen der nicht-bestrahlten Schicht- bzw. Folienteile und gegebenenfalls durch nachfolgendes Tempern, unter Verwendung von Photopolymeren in Form von Additionsprodukten aus einem olefinisch ungesättigten Monoisocyanat und einem Phenol-Formaldehyd-Harz, **dadurch gekennzeichnet**, daß als olefinisch ungesättigtes Monoisocyanat ein methacrylatgruppenhaltiges Isocyanat oder ein Additionsprodukt von Hydroxyethyl(meth)acrylat an 2.4-Diisocyanatotoluol eingesetzt wird.

2. Verfahren nach Anspruch 1, **dadurch gekennzeichnet,** daß die Photopolymeren zusammen mit licht- oder strahlungsempfindlichen copolymerisationsfähigen Verbindungen, insbesondere acrylat- und methacrylatgruppenhaltigen Verbindungen, eingesetzt werden.

3. Verfahren nach Anspruch 1 oder 2, **dadurch gekennzeichnet,** daß die Photopolymeren zusammen mit Photoinitiatoren und/oder Photosensibilisatoren, insbesondere α-Halogenacetophenonen, Dialkoxyacetophenonen, Benzoylphosphinoxiden und Michler's Keton, eingesetzt werden.

4. Verfahren nach einem der Ansprüche 1 bis 3, **dadurch gekennzeichnet,** daß als Phenol-Formaldehyd-Harz Novolake verwendet werden.

5. Verfahren nach einem oder mehreren der Ansprüche 1 bis 4, **dadurch gekennzeichnet,** daß mineralische Füllstoffe zugesetzt werden.

6. Wärmebeständige strukturierte Schicht, hergestellt nach einem oder mehreren der Ansprüche 1 bis 5.

7. Verwendung der strukturierten Schicht nach Anspruch 6 als Lötstopp- und Isolierschicht mit dauerhafter Schutzfunktion in der Feinleitertechnik.

8. Verwendung der strukturierten Schicht nach Anspruch 6 als Resist mit intermediärer Schutzfunktion bei Strukturübertragungsprozessen durch Galvanisieren, Naß- und Trockenätzen sowie durch Ionenimplantation.

9. Verwendung der strukturierten Schicht nach Anspruch 6 als Schutz- und Isolierstoff in der Elektrotechnik, insbesondere in der Halbleitertechnik.

10. Verwendung der strukturierten Schicht nach Anspruch 6 als Dämpfungsmasse für Oberflächenwellenfilter.

11. Verwendung der strukturierten Schicht nach Anspruch 6 als α-Strahlenschutz auf den Zellenfeldern von Speicherbausteinen.

12. Verwendung der strukturierten Schicht nach Anspruch 6 als Orientierungsschicht in Flüssigkristalldisplays.

13. Verwendung der strukturierten Schicht nach Anspruch 6 als Dielektrikum bei der Mehrlagenverschaltung.

## Claims

1. Method for manufacturing heat-resistant structured layers by applying photosensitive soluble polymers in the form of a layer or foil onto a substrate, irradiating the layer or foil through negative patterns with actinic light or by conducting a light, electron, laser or ion-beam, removing the non-irradiated layer or foil parts and if necessary by tempering following thereon, with the use of photopolymers in the form of addition products of an olefinically unsaturated monoisocyanate and a phenol-formaldehyde resin, characterised in that an isocyanate containing methacrylate groups or an addition product of hydroxyethyl(meth)acrylate to 2.4-diisocyanatotoluene is used as an olefinically unsaturated monoisocyanate.

2. Method according to claim 1, characterised in that the photopolymers are employed together with light or photosensitive compounds capable of copolymerisation, in particular compounds containing acrylate and methacrylate groups.

3. Method according to claim 1 or 2, characterised in that the photopolymers are employed together with photo-initiators and/or photosensitizers, in particular α-halogenacetophenones, dialkoxyacetophenones, benzoyl phosphinoxides and Michler's ketone.

4. Method according to one of claims 1 to 3, characterised in that novolaks are used as phenol-formaldehyde resin.

5. Method according to one or more of claims 1 to 4, characterised in that mineral fillers are added.

6. Heat-resistant structured layer manufactured according to one or more of claims 1 to 5.

7. Application of the structured layer according to claim 6 as a solder-stopping and insulating layer with a lasting protective function in fine conductor technology.

8. Application of the structured layer according to claim 6 as a resist with an intermediary protective function with structure transmission processes by galvanising, wet and dry etching, as well as by ion-implantation.

9. Application of the structured layer according to claim 6 as a protective and insulating material in electro-technology, in particular in semiconductor technology.

10. Application of the structured layer according to claim 6 as an attenuation measure for surface wave filters.

11. Application of the structured layer according to claim 6 as an α-radiation protection on the cell fields of storage modules.

12. Application of the structured layer according to claim 6 as an orienting layer in liquid crystal displays.

13. Application of the structured layer according to claim 6 as a dielectric with multi-layer circuitry.

## Revendications

1. Procédé de fabrication de couches structurées et résistantes à la chaleur, en déposant sur un substrat des polymères solubles et sensibles au rayonnement sous la forme d'une couche ou d'une feuille mince, en exposant la couche ou la feuille mince à travers des originaux négatifs à de la lumière actinique, ou en y envoyant un faisceau lumineux, électronique, laser ou ionique, en éliminant les parties non exposée de la couche ou de la feuille mince et, le cas échéant, en effectuant ultérieurement un recuit avec utilisation de polymères photosensibles sous forme d'adduits d'un monoisocyanate à insaturation oléfinique et d'une résine phénolformaldéhyde, caractérisé en ce qu'il consiste à utiliser comme monoisocyanate à insaturation oléfinique un isocyanate contenant un groupe méthacrylate ou un adduit de 2,4-diisocyanatotoluène et d'un acrylate ou d'un méthacrylate d'hydroxyéthyle.

2. Procédé suivant la revendication 1, caractérisé en ce qu'il consiste à utiliser les polymères photosensibles avec des composés susceptibles de copolymériser et sensibles à la lumière ou au rayonnement, notamment des composés contenant des groupes acrylate et méthacrylate.

3. Procédé suivant la revendication 1 ou 2, caractérisé en ce qu'il consiste à utiliser les polymères photosensibles avec des photoinitiateurs et/ou des photosensibilisateurs, notamment des α-halogénoacétophénones, des dialcoxyacétophénones, des benzoylphosphinoxydes et la cétone de Michler.

4. Procédé suivant l'une des revendications 1 à 3, caractérisé en ce qu'il consiste à utiliser des novolaques comme résine phénolformaldéhyde.

5. Procédé suivant l'une ou plusieurs des revendications 1 à 4, caractérisé en ce qu'il consiste à ajouter des charges minérales.

6. Couche structurée et résistante à la chaleur, fabriquée selon l'une ou plusieurs des revendications 1 à 5.

7. Utilisation de la couche structurée selon la revendication 6 comme couche d'arrêt de soudure et isolant à fonction de protection durable dans la technique des conducteurs minces.

8. Utilisation de la couche structurée suivant la revendication 6 comme réserve à fonction de protection intermédiaire, lors de processus de transfert de structures par électrolyse, par gravure par voie sèche et par voie humide, ainsi que par implantation d'ions.

9. Utilisation de la couche structurée suivant la revendication 6 comme substance de protection isolante en électrotechnique, notamment dans la technique des semiconducteurs.

10. Utilisation de la couche structurée suivant la revendication 6 comme masse d'amortissement pour des filtres à ondes de surface.

11. Utilisation de la couche structurée suivant la revendication 6 comme protection vis-à-vis du rayonnement α sur les zones cellulaires de composants à mémoire.

12. Utilisation de la couche structurée suivant la revendication 6 comme couche d'orientation dans des affichages à cristaux liquides.

13. Utilisation de la couche structurée suivant la revendication 6 comme diélectrique dans les circuits multicouches.
